# EUROPEAN PATENT APPLICATION

(11) **EP 3 499 586 A1**
(43) Date of publication of application: **19.06.2019**
(21) Application number: 17830538.9
(22) Date of filing: 12.07.2017
(51) Int. Cl.: H01L 31/054, H02S 30/20, B64G 1/44

(54) **SOLAR ENERGY CONCENTRATOR WITH MOVABLE MIRRORS FOR USE IN FLAT SOLAR THERMAL COLLECTORS OR IN STATIC PHOTOVOLTAIC MODULES**

(30) Priority: 20.07.2016 ES 201630931 U
(71) Applicant: Seenso Renoval S.L., 28040 Madrid (ES)
(72) Inventor: AJONA MAEZTU, Jose Ignacio, 28040 Madrid (ES); GURUCHAGA GARCÍA, Ignasi, Santiago 7790195 (CL); GONZÁLEZ I CASTELVI, Daniel, 08640 Olesa de Montserrat (Barcelona) (ES)
(86) International application number: PCT/ES2017/070508
(87) International publication number: WO 2018/015598

(57) **Abstract**

The device is a cylindrical concentrator with a truncated cone cross-section, which uses mobile flat mirrors (1) rotating on axes parallel to the axis of the cylinder, with low concentration levels (typically < = 2). It has been specially designed to be coupled to solar thermal collectors and photovoltaic modules (2), even those that are commercially available, in such a way to increase their productivity and reduce the cost of energy generation, even when static. The essential feature of the device in this invention is that the tracking criterion of the mirror is to redirect the extreme ray (r1, r2,..., r'1, r'2,...) incident on the part of the mirror furthest away from the aperture without concentration towards the opposite end of the aperture without concentration. The fact that the mirrors are mobile means that the structures and systems protecting against wind, snow and overheating can be simplified.

## Description

### TECHNOLOGY SECTOR

Harnessing solar thermal energy to generate heat and photovoltaic solar energy to generate electricity.

### BACKGROUND OF THE INVENTION

A solar concentrator is a device that uses mirrors or lenses to redirect the incident radiation on a surface, called the aperture area, towards an exit area which is smaller than the aperture, where the thermal solar absorber or the photovoltaic module is placed in such a way that the energy density at the exit area is greater than that at the aperture.

The relationship between the aperture area and the exit area is called the geometric concentration ratio, or simply the concentration ratio, and is represented by the letter C.

Using mirrors to concentrate solar radiation is a very old technique (early twentieth century) and is widely used in solar energy systems to generate electricity through thermodynamic cycles at temperatures typically higher than 300°C. The most widespread solar energy concentrator devices for these purposes are parabolic trough solar collectors, heliostats, and parabolic dishes, usually based on cylindrical mirrors of parabolic section or on paraboloids of revolution or on their projection onto a plane surface in the case of Fresnel mirrors (see: J. F. Kreider and F. Kreith. Solar energy handbook McGraw-Hill series in modern structures (USA), 1981). The typical concentration ratios of these technologies range between 20 and 500. The mirrors in these technologies redirect solar radiation to a focus, either linear or a point, and require very precise tracking devices to follow the apparent motion of the sun.

For thermal applications and for applications requiring lower thermal levels (below 150°), cylindrical concentrating mirrors with curved transversal profiles (parabolic, or with an involute of the absorber) are also used, but they do not redirect the radiation to a single focus. These include CPC type collectors with curved mirrors and collectors that use fixed flat mirrors as concentrators. (see "Active Solar Collectors and Their Applications", Ari Rabl, Oxford University Press, 1985). In this family of non-focusing devices, the concentration ratio is usually less than 2, which means that they do not tend to use systems for tracking the apparent motion of the sun (fixed-tilt concentrators). To date, non-focusing concentrators, both with curved and with flat mirrors usually produce a very non-homogeneous distribution of radiation over the absorber, in some cases producing peaks in radiation that can cause problems in the operation of the collector.

Concentrators are much less widespread for photovoltaic applications, although there is significant interest in finding feasible technologies that can reduce the cost of photovoltaic electricity. Its use, especially for applications with low concentration C <2 using standard modules, has always clashed with the fact that photovoltaic modules perform worse when the temperature of the cells is increased and when the radiation received by each of the photovoltaic cells in the module is not the same. This explains why even the non-focusing concentrators (CPCs and cones) used to date have not worked well enough. Despite these limitations, research into photovoltaic concentration technology continues, in particular for very high concentrations (over 100) and with very efficient high-temperature cells (see "Current status of concentrator photovoltaic (CPV) Technology", Dr Simon P. Philipps et al, Fraunhofer ISE and NREL report, 2016). The remaining drawback is cost since, until now, the concentrators used have not offered clear advantages in terms of reducing the electricity cost of photovoltaic applications.

### EXPLANATION OF THE INVENTION

The device in this invention was published as utility model ES1162359Y. The device in this invention is a non-focusing cylindrical concentrator with a truncated cone cross-section, which uses movable flat mirrors rotating on an axis parallel to the axis of the cylinder and which shows low concentration levels (typically C <= 2). It has been specially designed to be coupled to thermal solar collectors (flat plate, evacuated tubular collectors,..), including those that are commercially available, so that although they are still fixed-tilt collectors, they are made more energy-efficient and may be used in applications that require heat at temperatures close to 150° with reasonable efficiency.

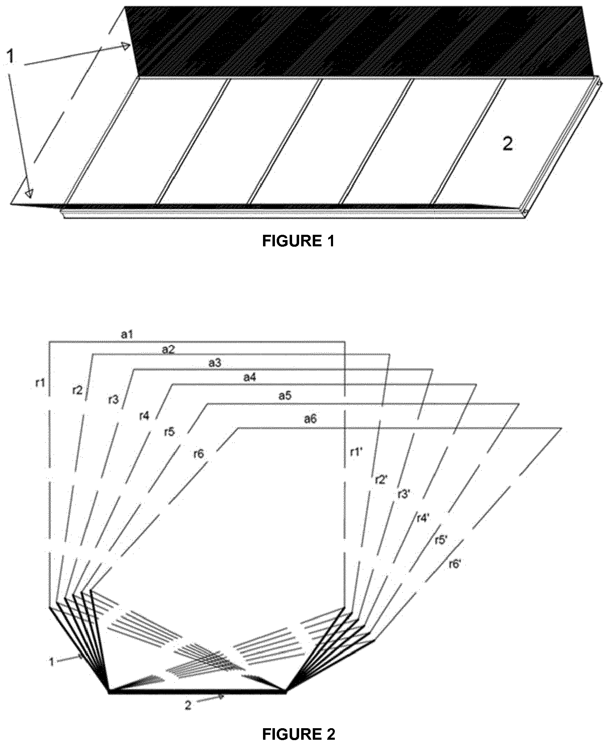

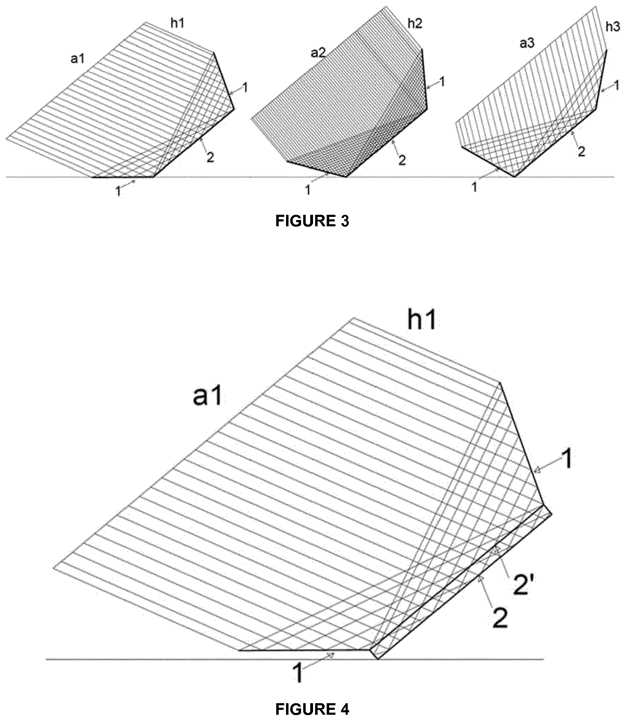

It can also be coupled to photovoltaic modules, including those that are commercially available, so that although they are still fixed-tilt modules, their productivity is increased, and the cost of photovoltaic generation is reduced. It can be assembled on the outside of these devices and can be adapted to the features of the frame and the available support structure, both for installations on flat roofs or terrains, and on sloped roofs or structures. The essential feature of the device in this invention (Figure 1) is that the flat mirrors (or mirror, if only one is used) in the concentrator move in such a way so as to uniformly redistribute the radiation available over the new aperture, on the old aperture without concentration (including absorbers or photovoltaic modules), avoiding the high local concentrations that are characteristic of focusing concentrators and CPCs. To achieve this -and taking into account the fact that for cylindrical concentrators the projection on the plane transversal to the concentrator (the one that is perpendicular to the axis of the cylinder) of the path of the reflected ray striking with a given angle of incidence on the aperture is independent from the longitudinal component of this angle of incidence- the mirror tracking criterion is to move it to redirect the extreme ray (the one striking the part of the mirror furthest away from the aperture without concentration) towards the opposite end of the surface of the aperture without concentration (Figures 2 and 3). An alternative to directing it towards the opposite end of the surface of the REAL aperture without concentration (one advantage of which is that it provides better access to the pivoting point of the mirrors to enable the mechanical assembly of the device in this invention) is to direct it towards the opposite end of the surface of the VIRTUAL aperture without concentration. This is defined as that aperture whose dimensions are identical to those of the real one and which is situated on a parallel plane and at an appropriate distance to, for example, reduce the aerodynamic load. It can be connected to the real one by way of flat mirrors that are perpendicular or quasi-perpendicular to the aperture without concentration, along all or part of its length. Figure 4 shows an example of a virtual aperture without concentration.

The dimensions of the device in this invention will be adapted to the dimensions of the solar thermal collector or to the photovoltaic (PV) module to which it is coupled. The device in this invention will provide concentration levels of around 2 for a transverse angle of incidence of zero with respect to the normal to the aperture, and thus a low level of precision is required for tracking the sun, and it can tolerate major errors without having a significant effect on solar productivity. An additional benefit of this tracking method is that the size of the aperture area (which is always assumed to be the area of the section of the incident solar ray contained in a plane parallel to the aperture without concentration which is redirected by the concentrator mirrors) increases slightly when the angle of incidence is increased, leading to an increase in concentration for angles of incidence with a projection on the transversal plane greater than 0°. To facilitate the construction of the device in this invention, the mirrors do not need reach the surface of the collector: its lower part may be truncated slightly.

Using the device in this invention with a single mirror could be of particular interest for improving existing installations, both thermal and photovoltaic, in which the distance between the different rows of solar thermal collectors or photovoltaic modules (or other arrangements) rules out the use of two mirrors (e.g. due to the shadows it would cast on the other rows) or when the demand profile shows a significant seasonal mismatch. At low latitudes, the option of a single mirror allows for high productivity options throughout the year, reaching concentrations of around C = 1.7 with a very low wind load and a terrain occupation factor greater than 40% without significant shade problems.

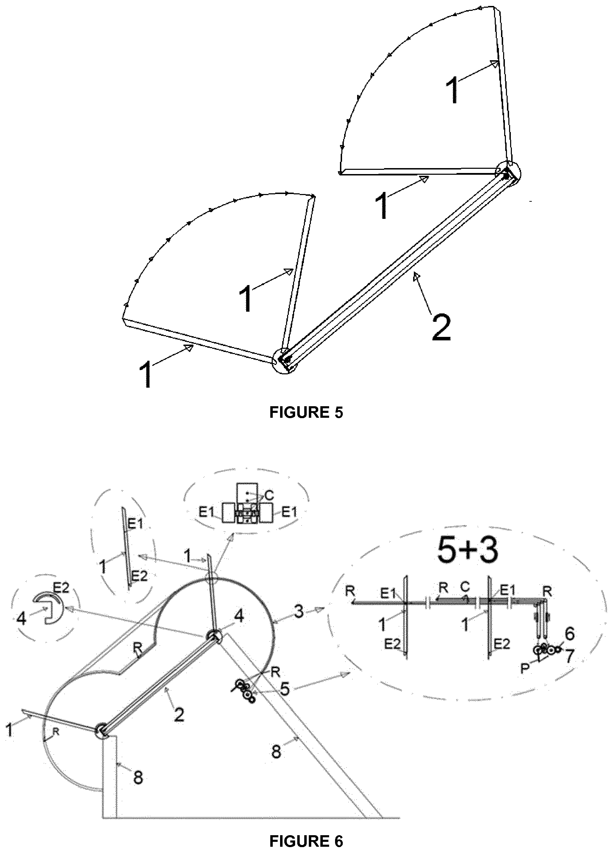

To optimize the performance of any solar thermal collector, it is necessary to find a compromise between elements that enable capture and those that reduce thermal losses (e.g. the glass used to cover the flat-plate collectors lowers thermal losses but reduces the radiation that reaches the absorber). This compromise will depend strongly on the intended working temperature and the required costs. The dimensions and shape of the device in this invention will be adapted to the features of the application in which it will be used, in particular the required working temperature, and will provide concentrations of between 1 and 2. The effect of this concentration is to reduce thermal losses per unit of the aperture area (thermal losses are proportional to the absorption area, which is the area with losses, and gains are proportional to the aperture area) at the expense of optical losses, due to the reflectivity of the mirror and the reduction in the capture of diffuse radiation. In doing so it aims to be more efficient. One factor to be controlled in thermal installations is when very high temperatures are reached in the absorber when the radiation level on the collector aperture is high and the absorber is not cooled down (e.g. when the control stops the circulation pump in primary circuit, when the maximum temperature in the solar storage is reached). The better the solar collector, the higher the temperature. Under these circumstances, a good thermal solar collector will reach temperatures of above 180°C (the so-called stagnation temperature). If a good thermal collector is coupled to an external concentrator with a concentration that is close to 2, the achievable stagnation temperatures may exceed 250°C. Although the materials used to make the collectors are selected for their ability to withstand stagnation temperatures, it is always preferable, both in terms of costs and durability and to simplify the operation of the solar harnessing system, to have passive methods for reducing the stagnation temperature. The device in this invention attempts to reconcile the increase in efficiency associated with concentration with a reasonable cost, without the drawbacks associated with an increase in the stagnation temperature. The fact that the concentrator mirrors in this device in this invention are mobile allows the mirror to be used for shade, blocking solar radiation (Figure 5) and avoiding high stagnation temperatures when necessary.

This protection position (with one or both mirrors folded) also has the advantage of minimizing dirtiness if the mirrors are folded during at night or when the plant is not in use, as well as reducing wind and snow loads, since when there are high wind speeds or heavy snowfall the mirrors would move in such a way as to reduce the area over which the wind would act or the snow would accumulate.

The device in this invention would ordinarily be installed on fixed-tilt collectors or modules tilted an angle on the horizontal close to the latitude of the location, oriented towards the equator (facing south in the northern hemisphere) or on horizontal or sloped collectors or modules arranged in rows from north to south, although tracking axes could be used with significant deviations with respect to these conditions, that is, in general the mirrors will track in the east-west axis or in the north-south , choosing the most advantageous option in each case. If we compare the device of the invention with the solar trackers with tracking on the east-west axis, or on the north-south axis, without concentration, for photovoltaic applications (for thermal applications the comparison is pointless since it does not use tracking without concentration), we see that this device has some interesting advantages. For the same aperture area, the occupation of the ground of photovoltaic fields can be increased by more than 15%, without significant shading problems between the various rows. In addition, for the same area of photovoltaic modules, it is possible to increase electricity production by more than 25% (considering that tracking improves production by around 20-30% compared with modules without tracking, and in the case of the device in this invention with a moderate concentration of 1.7, the modules work with a slightly lower efficiency as it is operated at a higher temperature). It is not necessary for the whole set of photovoltaic modules to move, since it is enough for just the mirrors to move. Support structures are lighter and protection against gusts of wind is simpler.

### BRIEF DESCRIPTION OF THE DRAWINGS

A set of drawings is included to complement the information contained in this document and to facilitate a better understanding of the invention's features. These are an integral part of the document in which, with an illustrative and non-limiting character, the following are shown:
Figure 1 shows a schematic 3D view of the device in this invention (1) coupled to a solar thermal collector or photovoltaic module (PV).
Figure 2 shows a schematic view of the projection on the cross-section of the path of the incidental extreme rays on the left (r1, r2, r3, ...) and on the right (r1', r2', r3', ...) over the aperture a(i) defined between the rays r(i) and r(i') (i = 1, 2, 3, ...) of the device in this invention (1) with two mirrors in different positions. It shows how the rays striking the upper part of the mirror (extreme ray) are reflected towards the opposite end of the aperture without concentration (2). For each angle of incidence of radiation over the aperture, the mirrors move to redirect the extreme ray to the same point on the aperture without concentration.
Figure 3 shows, for a concentrator coupled to a collector or PV module sloped on the horizontal and using mirrors with east-west tracking, a schematic view of the effect of redirection, in its projection on the cross section, on the incident solar radiation rays h1, h2, and h3, of the device in this invention (1) with two mirrors towards the solar thermal collector or PV module (2). It shows the incidence with different angles of transversal incidence of the solar radiation rays h1, h2 and h3 on the apertures a1, a2 and a3 of the collector and how they are redirected to the aperture without concentration by changing the position of the mirrors. It is important to emphasise the uniformity of the radiation distribution over the aperture without concentration, since the mirrors illuminate it uniformly.
Figure 4 shows a schematic view, similar to Figure 3 but with the device designed for a virtual aperture without concentration (2'), of the effect of redirection, in its projection on the cross section, on incident solar radiation ray h1, of the device in this invention (1) with two mirrors towards the virtual solar thermal collector or PV module (2') and then towards the real one (2).
Figure 5 shows a schematic view of the cross-section of a possible protection or stow position of the solar collector or PV module (2) of the device in the invention (1): the device can fold up the mirrors to prevent solar radiation from reaching the aperture without concentration. The protection position also aims to reduce the effects of wind and snow.
Figure 6 shows a detailed view of a possible preferred embodiment of the invention, coupled to a collector or PV module sloped on the horizontal and using mirrors with east-west tracking, with its various components. The device in the invention (1) is shown with the detail of the mirror and its structure and the two axes E1 and E2 along which it slides on the upper guide (3) and the lower one (4), respectively (also shown in detail (4) with the slot through which the mirror slides and adapts to enable it to couple to the side profile of the solar collector or PV module). The diagram also shows the solar thermal collector or PV module (2), the connection system to the tracking motor or actuator (6), details of the cables, chains (C) and pulleys or wheels (R) connected to a gear system with a lever (P). When in use, this changes the position of the gear system when the motor has no source of power and allows the mirrors to move in the same direction when the motor or actuator is in use (6), or in opposite directions when the motor (6) is not powered, by way of an energy accumulation device (e.g. a torsion spring) (7) connected to the same axle that moves the motor or actuator. The support structure (8) of both the collector and the concentrator is also shown.

### PREFERRED EMBODIMENT OF THE INVENTION

The device in the invention can be used in several ways. The diagrams and the way in which they have been numbered show a preferred embodiment of the invention, making use of the parts and elements shown. This is described in detail below.

Thus Figure 6 shows a possible preferred embodiment of the solar energy concentrator device, with movable mirrors for use in fixed tilt thermal solar collectors or fixed-tilt photovoltaic modules. The device in this invention, in its preferred embodiment, comprises (when connected to a standard flat-plate collector):
1. Concentrator mirrors (1 or 2 units) with a high level of solar reflectivity (e.g. glass and silver or aluminium foil) and its support structure to ensure that it has the necessary rigidity;
2. Solar collector, whose main components are the absorber, the glass, the thermal insulation and the box in which all these elements are housed (included in the description because, while not part of the device itself, it determines the device's dimensions and shape);
3. Guide along which the axle connected to the mirror support structure at the top, which carries the mechanical loads to the general structure, slides or rotates. The right and left mirror guides can be connected to ensure that the structure has the necessary rigidity;
4. Guide along which the axle connected to the structure of the mirror support at the bottom slides or rotates;
5. Connection to the tracking motor/actuator, either separate for each mirror or common to both, by means of gears and cables or traction chains, or any other equivalent device, connected to the axle which is connected to the mirror's support structure. It may include a pulley inside the guide. It allows the mirrors to move in the same direction when tracking, or in opposite directions when the mirrors move into the stow or protection position;
6. Actuator that moves the mirrors during tracking, usually powered by electricity either from the grid, from batteries, or directly from photovoltaic modules;
7. Energy storage device (e.g. torsion spring) required to move the mirrors when there is no power supply from the grid to power the motor or actuator into the stow or protection position;
8. Support structure of both the collector and the concentrator.

As indicated, the mirror (or usually, mirrors) of the concentrator (1) moves along the guides (3) and (4) to track the apparent motion of the sun and to move into the protection position. The guides can be replaced by an equivalent mechanism that would cause the mirrors to rotate on the desired axis. An external actuator (6) is needed for tracking (e.g. an electric motor). As an additional safety measure when there is no power to the motor, it is possible to connect a torsion spring (7) or other means of energy accumulation to the gear system so that the mirrors move into the protection position, using the accumulated energy. Given that during solar tracking the mirrors (or mirror, if there is only one) have to move in the same direction (both to the left or both to the right along a horizontal plane), and that moving into the protection position may require both mirrors to move in opposite directions towards the centre of the concentrator, a mechanism is provided in (5) and shown in Figure 6 which, in this situation, would automatically change the direction of rotation of one of the actuators on the mirrors, without the need for the motor to be powered using electricity.

It is worth noting that the mirror guide (3) also acts as a structure that can transmit loads to the support structure (8). In an ideal optical approach, the mirror should extend from the aperture and touch the aperture without concentration. However, this is not possible when the device in this invention is being used with a standard flat-plate solar collector, since the absorber is not accessible because of the glass, and the mirror's centre of rotation is below the glass. The lower part of the pivoting point of the mirror must be placed in a concentric groove (4) with the mirror-rotating axis. To mitigate this situation, the lower part of the mirror and its support structure are truncated slightly to prevent the structure from impacting with the glass when the mirror is moving into the protection position. This would be the same if the device in this invention were used with a photovoltaic module, except that the mirror would be able to extend until it was almost touching the module. However, given the need to take into account the effects of aerodynamic and snow loads on the mirror, in most cases it would be advisable to leave a space between the module and the mirror.

### Industrial application

The solar energy concentrator with movable mirrors, as outlined in this document, will be manufactured for use with fixed tilt solar thermal collectors or fixed-tilt photovoltaic modules. It will be adapted to the specific dimensions of the solar collector (or collectors) or photovoltaic module (or modules) to which it will be coupled and to the application in which it will be used. Materials that are appropriate for its elements and components will be used: plastic, glass, ABS, or metal, taking into account their properties and cost.

## Claims

1. Non-focusing cylindrical concentrator (1) with a truncated cone cross-section to improve solar energy harnessing in fixed-tilt solar thermal collectors and in fixed-tilt PV modules (2). It is **characterized by** the use of mirrors that are essentially flat, movable, and that rotate on an axis parallel to the axis of the cylinder. These have been selected to track the apparent motion of the sun and to act as sunlight concentrators, and **characterized by** their inclusion of the following:
• One or two flat mobile mirrors rotating on the selected axis to track the apparent motion of the sun (1), increasing the incident solar radiation on the collector or module
• Coupling of the mirrors to a fixed-tilt thermal solar collector or to a fixed-tilt PV module (2)
• Guiding channels on the upper part (or equivalent) of the mirrors, acting as a mobilizer and support for the aforementioned mirrors (3) or other equivalent mechanism.
• Guides along which the axle connected to the lower part of the mirrors' support structure slide (4), or other equivalent mechanism that causes the mirrors to rotate on the desired axle.
• Connection or connections to the tracking motor or motors using cables, chains, and pulleys (5), or other equivalent mechanism, allowing the mirrors to move in the same or opposite directions
• Actuator that moves the mirrors during tracking (6).
• Energy accumulation device (e.g. torsion spring) (7) that, if required, moves the mirrors when the actuator is not supplied with external electrical or mechanical power.
• Support structure (8) for the collector and the concentrator

2. Concentrator to improve solar energy harnessing as described in Claim 1, **characterized by** its flat concentrator mirrors with tracking axes that redirect the available radiation over the aperture towards the thermal absorber or photovoltaic module, achieving an essentially uniform distribution of solar radiation over the solar thermal collector or the photovoltaic module, and **characterized by** some components of the mirror do not contribute to the concentration, but act as a waveguide for the incident rays on the aperture, towards the absorber of the solar thermal collector or towards the photovoltaic module.

3. Concentrator to improve solar energy harnessing as described in Claim 1, **characterized by** the fact that its mirrors can move to protect the thermal solar collector or the photovoltaic module from solar radiation or wind and/or snow loads, without the need for an external power supply since it uses the power accumulated in a torsion spring or equivalent device.

4. Concentrator to improve solar energy harnessing as described in Claim 1, **characterized by** having a geometric concentration ratio, tracking axes, dimensions, and geometry that adjust to the dimensions of the solar thermal collector (or collectors) or photovoltaic module (or modules) and to the application for which it is being used.

5. Concentrator to improve solar energy harnessing as described in Claim 1, **characterized by** the fact that the tracking axis, solar concentration, and solar reflectivity of the mirrors are selected based on the thermal level of the application to which the solar device is providing heat and/or on the optimal cost-effectiveness of the thermal or electric energy generated using solar energy.
